# EUROPEAN PATENT APPLICATION

(11) **EP 4 131 711 A1**
(43) Date of publication of application: **08.02.2023**
(21) Application number: 21920241.3
(22) Date of filing: 21.01.2021
(51) Int. Cl.: H02J 7/00

(54) **WIRELESS CHARGING DEVICE AND WIRELESS CHARGING BASE**

(71) Applicant: Huawei Digital Power Technologies Co., Ltd., Shenzhen, Guangdong 518043 (CN)
(72) Inventor: HE, Li, Shenzhen, Guangdong 518129 (CN); WU, Baoshan, Shenzhen, Guangdong 518129 (CN); WU, Donghao, Shenzhen, Guangdong 518129 (CN); WU, Chenglong, Shenzhen, Guangdong 518129 (CN)
(74) Representative: Huawei European IPR
(86) International application number: PCT/CN2021/073049
(87) International publication number: WO 2022/155838

(57) **Abstract**

This application discloses a wireless charging device and a wireless charging base. The wireless charging device includes an alignment mechanism and at least two transmit coils. The at least two transmit coils are in a one-to-one correspondence with at least two electronic devices. Each transmit coil wirelessly charges a corresponding electronic device. Charging regions formed by the transmit coils on a charging plane are interconnected or overlap. The alignment mechanism drives each transmit coil to be aligned with a receive coil in a corresponding electronic device, and the transmit coil wirelessly charges the corresponding electronic device. The charging regions formed by the transmit coils are contiguous, and the charging regions covered by the transmit coils have no spacing in between and form a contiguous charging plane, in other words, a plurality of transmit coils form a relatively large charging region. The transmit coil in the wireless charging device provided in this application is movable, and therefore can be automatically aligned with the receive coil in the electronic device, thereby implementing place-and-charge of the electronic device, and improving a degree of freedom of wireless charging.

## Description

### TECHNICAL FIELD

This application relates to the field of wireless charging technologies, and in particular, to a wireless charging device and a wireless charging base.

### BACKGROUND

In a wireless charging technology (Wireless charging technology, WCT), a conduction medium such as an electric field, a magnetic field, a microwave, or a laser is used to wirelessly transmit electric energy. The wireless charging technology has advantages such as no wire restriction and no plugging, and therefore is increasingly widely used on electronic devices. Currently, wireless charging devices are used to wirelessly charge an increasing quantity of electronic devices. For example, the electronic device may be a mobile phone or a wearable device. The wireless charging device includes a transmit coil, and the electronic device includes a receive coil.

Currently, in the wireless charging technology, energy is transmitted through magnetic field coupling between the transmit coil and the receive coil, and the transmit coil and the receive coil need to be located within a specific spatial distance. For example, when the electronic device is a mobile phone or a wearable device, the electronic device is placed on the wireless charging device, and locations of the transmit coil and the receive coil may not be aligned. As a result, charging may fail, or charging efficiency may be low.

### SUMMARY

This application provides a wireless charging device and a wireless charging base, to implement automatic alignment between a transmit coil and a receive coil, implement place-and-charge for wireless charging, and improve a degree of freedom.

An embodiment of this application provides a wireless charging device. The wireless charging device may be a one-to-many charging device, and may simultaneously wirelessly charge at least two electronic devices. The wireless charging device includes an alignment mechanism and at least two transmit coils. Each transmit coil is configured to wirelessly charge a corresponding electronic device. One transmit coil corresponds to one electronic device. To be specific, with respect to one electronic device, only one transmit coil wirelessly charges the electronic device. Each of the at least two transmit coils forms a corresponding charging region on a charging plane, and charging regions corresponding to two adjacent transmit coils are interconnected or overlap, in other words, have no spacing in between. In this way, a large contiguous charging region is formed on a surface of the wireless charging device, and an electronic device can be randomly placed and wirelessly charged, provided that the electronic device is within the relatively large contiguous charging region, thereby improving a degree of freedom of charging. The charging plane is located on a surface, of surfaces of the wireless charging device, that is used for placing the electronic device. The transmit coils may be located on a same plane, or may be located on different planes. However, planes on which all the transmit coils are located are parallel to each other. The alignment mechanism drives transmit coils of the at least two transmit coils to be respectively aligned with receive coils of different receiving devices of the at least two electronic devices, so that the transmit coils wirelessly charge the corresponding electronic devices.

When the wireless charging device provided in this embodiment of this application performs wireless charging, each transmit coil corresponds to one electronic device. Therefore, the transmit coil may be made into a relatively large size, to increase a charging power. In addition, the charging regions formed by the transmit coils are contiguous, in other words, have no spacing in between. Therefore, an electronic device does not necessarily need to be placed within a specific range to be charged; instead, a location of a receive coil in the electronic device can be automatically detected, so that the alignment mechanism drives one of the transmit coils to be aligned with the receive coil of the electronic device, thereby implementing real place-and-charge, improving a degree of freedom of charging, and improving charging experience of a user.

In the wireless charging device provided in this embodiment of this application, only continuity between the charging regions formed by the transmit coils needs to be ensured, and no requirement is imposed on whether projections, on the charging plane, of center alignment regions corresponding to the transmit coils are contiguous. To be specific, the projections may be contiguous, or may have a specific spacing in between. For example, projections, on the charging plane, of center alignment regions corresponding to two adjacent transmit coils of the at least two transmit coils do not overlap, and the center alignment regions are regions in which centers of the at least two transmit coils may be respectively aligned with centers of receive coils of different receiving devices of the corresponding at least two electronic devices. In another possible implementation, projections, on the charging plane, of center alignment regions corresponding to two adjacent transmit coils of the at least two transmit coils overlap, and the center alignment regions are regions in which centers of the at least two transmit coils may be respectively aligned with centers of receive coils of different receiving devices of the corresponding at least two electronic devices.

Usually, the alignment mechanism includes at least a motor. Each transmit coil generally corresponds to two motors, and the two motors may drive the transmit coil to move along an X-axis direction and a Y-axis direction. The motors in the alignment mechanism provided in this embodiment of this application may be classified into two types: A first type is that a motor is fixed, and a second type is that a motor is movable.

The following first describes an implementation case in which a motor is fixed.

In the implementation case in which the motor is fixed, a quantity of alignment mechanisms is the same as a quantity of transmit coils, and the alignment mechanisms are in a one-to-one correspondence with the transmit coils. To be specific, at least two alignment mechanisms are included, and the at least two transmit coils are in a one-to-one correspondence with the at least two alignment mechanisms. Each alignment mechanism includes a first motor and a second motor. The first motor is configured to drive a corresponding transmit coil to move along a first direction. The second motor is configured to drive a corresponding transmit coil to move along a second direction. The first direction is perpendicular to the second direction.

Each alignment mechanism further includes a first guide rod, a second guide rod, a first screw rod, a second screw rod, and a coil support slider. The first screw rod and the second screw rod are perpendicular to each other, the first guide rod and the second guide rod are perpendicular to each other, the first screw rod is disposed along the first direction, and the second screw rod is disposed along the second direction. The coil support slider is sleeved at a junction between the first guide rod and the second guide rod, and the coil support slider is configured to support a corresponding transmit coil. The first motor is fastened at an end of the first screw rod, the first guide rod is sleeved on the first screw rod, and the first motor drives the first guide rod to move along the first screw rod. The second motor is fastened at an end of the second screw rod, the second guide rod is sleeved on the second screw rod, and the second motor drives the second guide rod to move along the second screw rod.

To enable the first guide rod to move more stably and the transmit coil to move more accurately, each alignment mechanism further includes a support rod. For each alignment mechanism, the support rod is disposed in parallel with the first screw rod. A first end of the first guide rod is sleeved on the first screw rod, and a second end of the first guide rod is sleeved on the support rod. The support rod is disposed in parallel with the first screw rod. In addition, the support rod may be alternatively disposed in parallel with the second screw rod. In this case, the support rod is configured to stabilize movement of the second guide rod. This is not specifically limited in this embodiment of this application. Alternatively, each alignment mechanism may include two guide rods, provided that space is sufficiently large, disposing of other components is not affected, and mutual interference does not occur during movement.

In a possible implementation, to place the transmit coil, each alignment mechanism generally further includes a tray. The tray is disposed on each coil support slider, and the tray is configured to carry a corresponding transmit coil.

In this embodiment of this application, whether the alignment mechanisms are arranged at one layer is not limited. The alignment mechanisms may be stacked, or may be arranged at one layer.

In a first possible implementation, the at least two alignment mechanisms are located on one plane. When a plurality of alignment mechanisms are located on one plane, in other words, are arranged at one layer, there may be a spacing between center alignment regions corresponding to the transmit coils due to an obstacle.

In a second possible implementation, the at least two transmit coils include at least three transmit coils, and the at least two alignment mechanisms include at least the following three alignment mechanisms: a first alignment mechanism, a second alignment mechanism, and a third alignment mechanism. The first alignment mechanism, the second alignment mechanism, and the third alignment mechanism are sequentially arranged along the first direction. Both the first alignment mechanism and the third alignment mechanism are at a first height in a vertical direction. The second alignment mechanism is at a second height in the vertical direction. The first height and the second height are different. Because two adjacent alignment mechanisms are stacked, there is no spacing between projections, on the charging plane, of center alignment regions corresponding to two adjacent transmit coils of the at least two transmit coils.

The following describes an implementation case of the second type: A motor is movable.

In this case, a quantity of alignment mechanisms is not distinguished, but the alignment mechanisms are considered as a whole. To be specific, the alignment mechanism includes N first motors, N second motors, one first screw rod, and N second screw rods, where N is a quantity of the at least two transmit coils, and N is an integer greater than or equal to 2. All the N first motors are movably sleeved on the first screw rod. The N second motors are in a one-to-one correspondence with the N second screw rods, each second motor is movably sleeved on a corresponding second screw rod, and corresponding transmit coils are respectively placed on the N second motors. All the N second screw rods are perpendicular to the first screw rod, the N second screw rods are in a one-to-one correspondence with the N first motors, and each second screw rod is fixed to a corresponding first motor.

A movement manner of the movable motor may include at least the following two implementations:

In a first possible implementation, there is no intersection between movement ranges on the first screw rod that respectively correspond to the first motors. In this solution with no intersection, there may be a spacing between center alignment regions corresponding to the transmit coils.

In a second possible implementation, there is an intersection between movement ranges on the first screw rod that respectively correspond to the first motors. In this solution with an intersection, because a movement range of each first motor is quite large, there may be no spacing between center alignment regions corresponding to the transmit coils, in other words, the center alignment regions are seamlessly connected, and there is really an overlapping region.

To enable each motor to move more stably, in a possible implementation, the alignment mechanism further includes one first guide rod and N second guide rods. The first guide rod is disposed in parallel with the first screw rod, the N second guide rods are in a one-to-one correspondence with and are disposed in parallel with the N second screw rods, and the N second motors are in a one-to-one correspondence with the N second guide rods. All the N first motors are movably sleeved on the first guide rod. Each second motor is movably sleeved on a corresponding second guide rod.

For the N second support guide rods and the N second screw rods, in a possible implementation, the alignment mechanism may further include a third guide rod disposed in parallel with the first guide rod. N sliders are arranged on the third guide rod. The N sliders are in a one-to-one correspondence with the N second guide rods, and the N sliders are in a one-to-one correspondence with the N second screw rods. The second screw rods and the second guide rods each are connected to a corresponding slider.

Generally, each transmit coil is disposed on a tray. Therefore, in a possible implementation, the alignment mechanism further includes N trays, and the N trays are in a one-to-one correspondence with the N second motors. Each tray is disposed on a corresponding second motor, and each tray is configured to carry a corresponding transmit coil. In addition, a slider may be further included. The slider is disposed on the second motor, a tray is disposed on the slider, and the slider is fixed to the tray.

In a possible implementation, a height of the N trays is adjustable, so that the at least two transmit coils are respectively located on different planes. When the slider is included, a height of the slider is adjustable. Because the slider is fixed to the tray, when the height of the slider is changed, a height of the tray varies accordingly, thereby affecting a height of a corresponding transmit coil, so that the transmit coil is not subject to interference from other components during movement.

In a possible implementation, the wireless charging device further includes a circuit board. The circuit board may include the following three layouts:

In a first layout, the alignment mechanism and the circuit board are stacked in the vertical direction, and the vertical direction is a direction perpendicular to the charging plane.

In a second layout, the circuit board and the alignment mechanism are located at one layer, and the circuit board and the alignment mechanism are arranged side by side.

In a third layout, the circuit board and the alignment mechanism are located at one layer, and the circuit board surrounds a periphery of the alignment mechanism.

The wireless charging device provided in this embodiment of this application is a one-to-many charging device. Therefore, when the wireless charging device charges a plurality of electronic devices, a plurality of transmit coils are all heated. Therefore, a heat dissipation issue is critical to the one-to-many charging device. In a possible implementation, the wireless charging device further includes an upper housing and a flat plate. The flat plate is disposed directly under the upper housing, and the upper housing is disposed in parallel with the flat plate. An air vent is provided on the flat plate. A gap layer is provided between the upper housing and the flat plate. An air duct is provided at a location, on a side surface of the wireless charging device, that corresponds to the gap layer. Cold air enters the gap layer through the air duct, and enters an inner cavity of the wireless charging device through the air vent on the flat plate, to dissipate heat for the transmit coil.

In addition, to limit or indicate a manner of an electronic device, in a possible implementation, N grooves may be provided on an outer surface of the upper housing of the wireless charging device, where N is a quantity of transmit coils, and N is an integer greater than or equal to 2. The N grooves are configured to limit a location of an electronic device whose size is smaller than a size of the groove, and the groove is further configured to indicate a placement location of an electronic device whose size is greater than the size of the groove during wireless charging.

In addition, to control operating of the alignment mechanism, in a possible implementation, the wireless charging device may further include a controller, configured to control the alignment mechanism to drive transmit coils of the N transmit coils to be respectively aligned with receive coils of different receiving devices of the at least two electronic devices. The controller may detect a location of a receive coil in each electronic device, to control the alignment mechanism to drive each transmit coil to be aligned with a corresponding receive coil.

Based on the wireless charging device provided in the foregoing embodiment, an embodiment of this application further provides a wireless charging base, configured to wirelessly charge at least two electronic devices, and including a power interface, an upper cover, a lower cover, an alignment mechanism, and at least two transmit coils. The alignment mechanism and the at least two transmit coils are located in a cavity formed by the upper cover and the lower cover. The power interface is disposed on a side of the cavity. The power interface is configured to connect a direct current transmitted by an adapter. The transmit coils are in a one-to-one correspondence with the electronic devices. Each of the at least two transmit coils forms a corresponding charging region on a charging plane. Charging regions corresponding to two adjacent transmit coils are interconnected or overlap. The charging plane is located on a surface, of surfaces of the wireless charging device, that is used for placing the electronic device. The alignment mechanism is configured to drive transmit coils of the at least two transmit coils to be respectively aligned with receive coils of different receiving devices of the at least two electronic devices, so that the transmit coils wirelessly charge the corresponding electronic devices.

In a possible implementation, the at least two transmit coils include N transmit coils, and the N transmit coils simultaneously wirelessly charge N different electronic devices.

It can be learned from the foregoing technical solutions that embodiments of this application have the following advantages:

The wireless charging device provided in embodiments includes N transmit coils, where N is an integer greater than or equal to 2, in other words, the wireless charging device may simultaneously wirelessly charge a plurality of electronic devices. The transmit coils are in a one-to-one correspondence with receive coils in the electronic devices, in other words, one transmit coil is only responsible for charging an electronic device aligned with the transmit coil. In addition, each transmit coil in the wireless charging device may move under driving by the alignment mechanism, to be aligned with a receive coil in a corresponding electronic device, thereby improving charging efficiency. Charging regions formed, on the charging plane, by the transmit coils of the wireless charging device provided in embodiments of this application are interconnected or overlap, in other words, are contiguous. To be specific, the charging regions covered by the transmit coils have no spacing in between, and can form a contiguous charging plane, in other words, a plurality of transmit coils form a relatively large charging region, thereby really implementing place-and-charge of an electronic device, and improving a degree of freedom of wireless charging.

### BRIEF DESCRIPTION OF DRAWINGS

FIG. 1 is a schematic diagram of a wireless charging device according to an embodiment of this application;
FIG. 2 is a schematic diagram of a charging region of a wireless charging device according to an embodiment of this application;
FIG. 3 is a schematic diagram of still another wireless charging device according to an embodiment of this application;
FIG. 4 is a schematic diagram of a plurality of transmit coils that corresponds to FIG. 3 according to an embodiment of this application;
FIG. 5 is a schematic diagram of another wireless charging device according to an embodiment of this application;
FIG. 6 is a side view of three alignment mechanisms according to an embodiment of this application;
FIG. 7 is a three-dimensional diagram of another wireless charging device according to an embodiment of this application;
FIG. 8 is a schematic diagram of still another wireless charging device according to an embodiment of this application;
FIG. 9 is a simplified diagram corresponding to FIG. 7 according to an embodiment of this application;
FIG. 10 is a schematic diagram in which there is no spacing between projections of charging regions formed by three transmit coils according to an embodiment of this application;
FIG. 11 is a schematic diagram in which projections of center alignment regions corresponding to three transmit coils overlap according to an embodiment of this application;
FIG. 12 is an exploded view of a wireless charging device according to an embodiment of this application;
FIG. 13 is a schematic diagram in which an alignment mechanism and a circuit board are arranged side by side according to an embodiment of this application;
FIG. 14 is a schematic diagram in which a circuit board surrounds an alignment mechanism according to an embodiment of this application;
FIG. 15 is a top view of an upper housing according to an embodiment of this application;
FIG. 16 is a top view of another upper housing according to an embodiment of this application;
FIG. 17 is a top view of still another upper housing according to an embodiment of this application;
FIG. 18 is a schematic diagram of a heat dissipation part according to an embodiment of this application;
FIG. 19 is a side view of a heat dissipation part of a wireless charging device according to an embodiment of this application; and
FIG. 20 is a side view of an adjacent side surface corresponding to FIG. 19 according to an embodiment of this application.

### DESCRIPTION OF EMBODIMENTS

The following terms "first", "second", and the like are merely intended for a purpose of description, and shall not be understood as an indication or implication of relative importance or implicit indication of a quantity of indicated technical features. Therefore, a feature limited by "first", "second", or the like may explicitly or implicitly include one or more features. In the descriptions of embodiments of this application, unless otherwise specified, "a plurality of" means two or more than two.

In addition, in embodiments of this application, orientation terms such as "upper" and "lower" may include but are not limited to being defined relative to placement orientations of components shown in the accompanying drawings. It should be understood that these directional terms may be relative concepts and are used for relative descriptions and clarifications, and may vary accordingly based on changes of the placement orientations of the components in the accompanying drawings.

In this application, it should be noted that the term "connection" should be understood in a broad sense unless otherwise expressly specified and limited. For example, the "connection" may be a fixed connection, or may be a detachable connection, or may be an integral connection; may be a direct connection, or may be an indirect connection implemented by using a medium. In addition, the term " coupling" may be a manner of implementing an electrical connection for signal transmission. The "coupling" may be a direct electrical connection, or may be an indirect electrical connection through an intermediate medium.

An embodiment of this application relates to a wireless charging device. The wireless charging device is configured to wirelessly charge an electronic device. The wireless charging device may be connected to a power supply. For example, the wireless charging device has a Type C interface, and is connected to one end of an adapter through the Type C interface, and the other end of the adapter is connected to a mains supply, for example, a 220 V alternating current. The wireless charging device includes a transmit coil, and the electronic device includes a receive coil. The power supply supplies power to the transmit coil in the wireless charging device. When the electronic device is close to the wireless charging device, an electromagnetic field of the transmit coil is coupled by the receive coil, so that energy obtained by the receive coil through coupling can charge a battery in the electronic device after conversion.

A type of the electronic device is not specifically limited in this embodiment of this application. For example, the electronic device may be a wireless device, for example, a mobile phone (Mobile Phone), a tablet computer (pad), a computer with a wireless transceiver function, an intelligent wearable product (for example, a smartwatch, a smart band, or a headset), a virtual reality (Virtual Reality, VR) terminal device, or an augmented reality (Augmented Reality AR) terminal device.

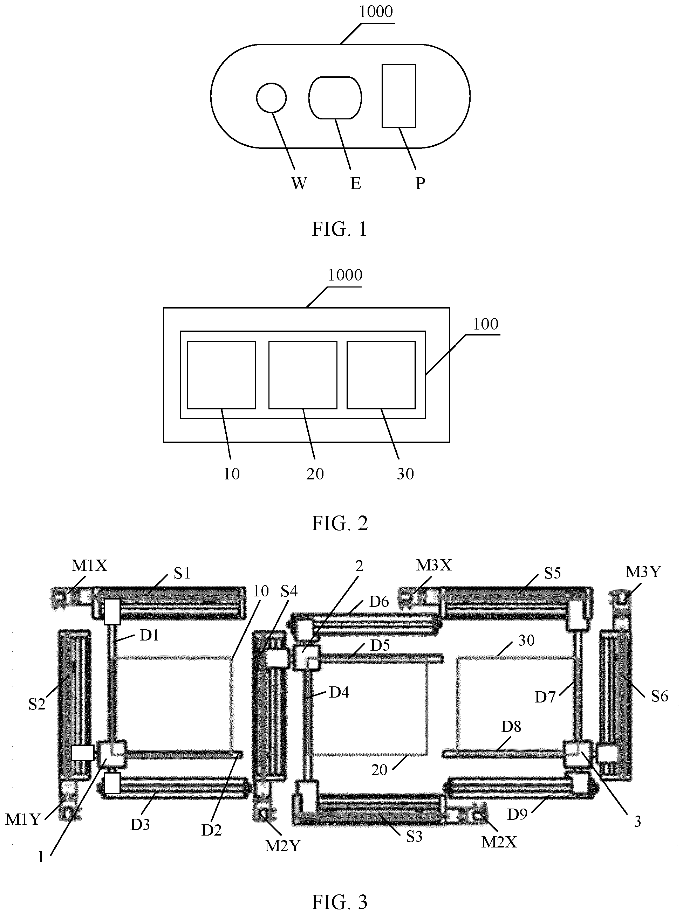

FIG. 1 is a schematic diagram of a wireless charging device according to an embodiment of this application.

FIG. 1 only shows that the wireless charging device 1000 is of a flat type. To be specific, the wireless charging device may be laid flat on a desktop during operating. In addition, the wireless charging device 1000 provided in this embodiment of this application may be alternatively of a three-dimensional type. For example, the wireless charging device 1000 may be placed on a desktop in another posture by using a bracket.

FIG. 1 shows an example in which the wireless charging device 1000 simultaneously charges three electronic devices of different types. The three electronic devices of different types are respectively a mobile phone P, a watch W, and a headset E. It should be understood that, alternatively, the wireless charging device 1000 may simultaneously wirelessly charge three electronic devices of one type, for example, simultaneously charge three mobile phones.

FIG. 1 shows an example in which an appearance of the wireless charging device is in an elliptic shape. The appearance of the wireless charging device is not limited in this embodiment of this application, and may be in a circular shape, a rectangular shape, or the like. In addition, the wireless charging device may be alternatively in a three-dimensional shape.

In a conventional one-to-many wireless charging device, a plurality of independent chargers are simply integrated into one housing, and a transmit coil is non-movable. To be specific, the transmit coil cannot be aligned with a receive coil in an electronic device, and place-and-charge cannot be implemented. In addition, another conventional one-to-many wireless charging device includes a plurality of transmit coils, and the plurality of transmit coils are arranged in an array. When an electronic device is placed on the wireless charging device, several transmit coils are selected from the transmit coils arranged in an array to charge the electronic device. Because the array-type transmit coils include many transmit coils, a charging region corresponding to a single transmit coil is relatively small, a charging power is relatively low, and charging efficiency is relatively low.

In this application, to address technical issues of place-and-charge and charging efficiency of wireless charging, the wireless charging device provided in this embodiment of this application may simultaneously wirelessly charge a plurality of electronic devices, in other words, the wireless charging device is a one-to-many wireless charging device. The wireless charging device may include N transmit coils, where N is an integer greater than or equal to 2. The transmit coils are in a one-to-one correspondence with receive coils in the electronic devices. Each transmit coil in the wireless charging device may charge a corresponding electronic device. For example, the wireless charging device may simultaneously charge a mobile phone, a watch, and a Bluetooth headset case. The Bluetooth headset case includes a battery, and the battery may charge a Bluetooth headset. With respect to the wireless charging device provided in this embodiment of this application, a quantity of electronic devices that can be simultaneously charged is not limited. For example, the wireless charging device may simultaneously charge two electronic devices, or may simultaneously charge three electronic devices. It should be understood that the wireless charging device may alternatively charge only one electronic device, and other transmit coils are idle.

### Device Embodiment 1

A wireless charging device provided in this embodiment is configured to wirelessly charge at least two electronic devices. The wireless charging device includes an alignment mechanism and at least two transmit coils. The at least two transmit coils are in a one-to-one correspondence with at least two electronic devices, and each transmit coil is configured to wirelessly charge a corresponding electronic device. Projections, on a charging plane, of charging regions formed by transmit coils of the at least two transmit coils are contiguous. The charging plane is located on a surface, of surfaces of the wireless charging device, that is used for placing the electronic device. The alignment mechanism is configured to drive transmit coils of the at least two transmit coils to be respectively aligned with receive coils of different receiving devices of the at least two electronic devices, so that the transmit coils wirelessly charge the corresponding electronic devices.

The transmit coils in the wireless charging device provided in this embodiment of this application are in a one-to-one correspondence with the electronic devices. To be specific, when an electronic device is charged, only one transmit coil in the wireless charging device corresponds to a receive coil in the electronic device to charge the electronic device. A plurality of transmit coils do not simultaneously charge one electronic device. This is different from a case of a conventional one-to-many wireless charging device. In addition, the charging regions formed by the transmit coils of the wireless charging device provided in this embodiment of this application are contiguous. To be specific, the charging regions covered by the transmit coils have no spacing in between on the charging plane, and can form a contiguous charging plane, in other words, a plurality of transmit coils form a relatively large charging region. The charging plane is located on a surface, of surfaces of the wireless charging device, that is used for placing the electronic device. In addition, the transmit coil in the wireless charging device provided in this embodiment of this application is movable, and therefore can be automatically aligned with the receive coil in the electronic device, thereby implementing place-and-charge of the electronic device, and improving a degree of freedom of wireless charging.

The wireless charging device provided in this embodiment of this application includes the alignment mechanism and the at least two transmit coils. A plurality of transmit coils may be selected, and a specific quantity is not limited in this embodiment of this application. The transmit coils are in a one-to-one correspondence with the electronic devices, and each transmit coil is configured to charge an electronic device corresponding to the transmit coil. In other words, N transmit coils are in a one-to-one correspondence with receive coils in N electronic devices. The alignment mechanism may drive each transmit coil to move in a corresponding region, to implement alignment between the transmit coil and a receive coil. Each transmit coil forms a corresponding charging region, and each transmit coil also forms a corresponding center alignment region. It should be understood that the charging region is different from the center alignment region. The center alignment region is a region in which a center of the transmit coil can be aligned with a center of a receive coil of a corresponding electronic device. However, an area covered by the charging region is larger than an area of the center alignment region, because wireless charging can still be performed when the center of the transmit coil deviates from the center of the receive coil.

To enable persons skilled in the art to better understand the wireless charging device provided in this embodiment of this application, the following describes a difference between the center alignment region and the charging region with reference to the accompanying drawings.

FIG. 2 is a schematic diagram of a charging region of a wireless charging device according to an embodiment of this application.

FIG. 2 is described by using an example in which the wireless charging device 1000 provided in this embodiment of this application includes three transmit coils.

Center alignment regions corresponding to the three transmit coils are a first center alignment region 10, a second center alignment region 20, and a third center alignment region 30. The three transmit coils form a contiguous charging region 100. It can be learned from FIG. 2 that an area covered by the charging region 100 is larger than a sum of areas covered by the first center alignment region 10, the second center alignment region 20, and the third center alignment region 30. Therefore, it can be learned that a charging region formed by each transmit coil is larger than a center alignment region.

In the wireless charging device provided in this embodiment of this application, charging regions formed by the transmit coils are contiguous. The being contiguous includes that projections of the charging regions are seamlessly connected, or may be that projections of the charging regions overlap. However, the charging regions formed by the transmit coils of the wireless charging device provided in this embodiment of this application have no spacing in between, but form a relatively large charging plane, to implement real place-and-charge. To be specific, projections, on the charging plane, of center alignment regions corresponding to two adjacent transmit coils of the at least two transmit coils do not overlap, and the center alignment regions are regions in which centers of the at least two transmit coils may be respectively aligned with centers of receive coils of different receiving devices of the corresponding at least two electronic devices. Alternatively, projections, on the charging plane, of center alignment regions corresponding to two adjacent transmit coils of the at least two transmit coils overlap, and the center alignment regions are regions in which centers of the at least two transmit coils may be respectively aligned with centers of receive coils of different receiving devices of the corresponding at least two electronic devices.

The alignment mechanism provided in this embodiment of this application includes a motor. Each transmit coil corresponds to two motors. The two motors are respectively configured to drive the transmit coil to move along a first direction and a second direction. The first direction is perpendicular to the second direction. The motor provided in this embodiment of this application may move on a screw rod, or may be fixed to a screw rod and cannot move.

The following first describes an implementation in which the motor is fixed with reference to the accompanying drawings. In a wireless charging device with fixed motors, N transmit coils are in a one-to-one correspondence with N alignment mechanisms, and each alignment mechanism includes a first motor and a second motor.

### Device Embodiment 2

FIG. 3 is a schematic diagram of still another wireless charging device according to an embodiment of this application.

FIG. 3 shows locations of three transmit coils. In FIG. 3, the three transmit coils are located on support sliders. To clearly describe the locations of the transmit coils, the support sliders are not described below, and descriptions are provided based on that locations of the support sliders are equivalent to the locations of the transmit coils. The three transmit coils are a first transmit coil 1, a second transmit coil 2, and a third transmit coil 3.

Two motors corresponding to the first transmit coil 1 are a first motor M1X and a second motor M1Y

The first motor M1X is configured to drive the first transmit coil 1 to move along a first direction. The first direction is an X direction, namely, a horizontal direction.

The second motor M1Y is configured to drive the first transmit coil 1 to move along a second direction. The second direction may be a Y direction, namely, a vertical direction. The first direction is perpendicular to the second direction.

Each alignment mechanism further includes a first guide rod D1, a second guide rod D2, a first screw rod S1, a second screw rod S2, and a coil support slider.

The first screw rod S1 is perpendicular to the second screw rod S2. The first guide rod D1 is perpendicular to the second guide rod D2. The first screw rod S1 is disposed along the first direction. The second screw rod S2 is disposed along the second direction.

The coil support slider is sleeved at a junction between the first guide rod D 1 and the second guide rod D2, and the coil support slider is configured to support a transmit coil. A location of the first transmit coil 1 in FIG. 3 is a location of the coil support slider. The transmit coil is fixed above the coil support slider. A connection between the coil support slider and the first guide rod D1 and a connection between the coil support slider and the second guide rod D2 are movable connections. To be specific, the coil support slider may slide along the first guide rod D1, or may slide along the second guide rod D2. In this way, when the guide rod moves along the screw rod, the coil support slider is driven to move, so that the transmit coil moves, and the transmit coil is finally aligned with a receive coil in an electronic device.

The first motor M1X is fastened at an end of the first screw rod S1, the first guide rod D1 is sleeved on the first screw rod S1, and the first motor M1X drives the first guide rod D1 to move along the first screw rod S1.

The first guide rod D1 is perpendicular to the first screw rod S1, and the first screw rod S1 is disposed along the X direction. Therefore, the first guide rod D1 is disposed along the Y direction. When the first motor M1X drives the first screw rod S 1, the first guide rod D1 moves along the first screw rod S1, so that the first transmit coil 1 moves along the X direction.

Similarly, the second motor M1Y is fastened at an end of the second screw rod S2, the second guide rod D2 is sleeved on the second screw rod S2, and the second motor M1Y drives the second guide rod D2 to move along the second screw rod S2.

The second guide rod D2 is perpendicular to the second screw rod S2, and the second screw rod S2 is disposed along the Y direction. Therefore, the second guide rod D2 is disposed along the X direction. When the second motor M1Y drives the second screw rod S2, the second guide rod D2 moves along the second screw rod S2, so that the first transmit coil 1 moves along the Y direction.

The foregoing describes the alignment mechanism corresponding to the first transmit coil 1. The following describes an alignment mechanism corresponding to the second transmit coil 2 with reference to FIG. 3. It can be learned from FIG. 3 that, to reduce an area occupied by all alignment mechanisms, the alignment mechanism corresponding to the second transmit coil 2 and the alignment mechanism corresponding to the first transmit coil 1 may be arranged in a staggered manner.

A first motor M2X in the alignment mechanism corresponding to the second transmit coil 2 is fastened at an end of a first screw rod S3. A difference from the alignment mechanism corresponding to the first transmit coil 1 lies in that the first screw rod S3 corresponding to the second transmit coil 2 is disposed on an opposite side of the first screw rod S1 corresponding to the first transmit coil 1, to implement a staggered layout, and make full use of space of the wireless charging device. In this way, a structure of the alignment mechanism is more compact, and charging regions corresponding to the transmit coils are seamlessly connected.

The first screw rod S3 corresponding to the second transmit coil 2 is disposed along the X direction. A second screw rod S4 corresponding to the second transmit coil 2 is disposed along the Y direction. The first motor M2X is fastened at an end of the first screw rod S3. A second motor M2Y is fastened at an end of the second screw rod S4. An end of a first guide rod D4 is sleeved on the first screw rod S3. An end of a second guide rod DS is sleeved on the second screw rod S4.

The third transmit coil 3 corresponds to a first screw rod S5, the first screw rod SS is disposed along the X direction, and a first motor M3X is fastened at an end of the first screw rod S5. The third transmit coil 3 corresponds to a second screw rod S6, the second screw rod S6 is disposed along the Y direction, and a second motor M3Y is fastened at an end of the second screw rod S6. A first guide rod D7 is sleeved on the first screw rod S5, and the first guide rod D7 is perpendicular to the first screw rod S5. A second guide rod D8 is sleeved on the second screw rod S6, and the second guide rod D8 is perpendicular to the second screw rod S6.

An operating principle of the alignment mechanism corresponding to the second transmit coil 2 and an operating principle of the alignment mechanism corresponding to the third transmit coil 3 are similar to the operating principle of the alignment mechanism corresponding to the first transmit coil 1. For details, refer to the descriptions of driving the first transmit coil 1. Details are not described herein again.

In addition, to further enhance a support function, the alignment mechanism corresponding to each transmit coil may further include a support rod. As shown in FIG. 3, the alignment mechanism corresponding to the first transmit coil 1 may further include a support rod D3. The support rod D3 is disposed in parallel with the first screw rod S 1. A first end of the first guide rod D1 is sleeved on the first screw rod S 1. A second end of the first guide rod D1 is sleeved on the support rod D3. The support rod D3 is configured to support the first guide rod D1, so that the first guide rod D1 runs more smoothly along the X direction.

Similarly, the alignment mechanism corresponding to the second transmit coil 2 may also include a support rod, which is denoted as D6. The support rod D6 is disposed in parallel with the first screw rod S3. The support rod D6 is configured to support the first guide rod D4, so that the first guide rod D4 runs more smoothly along the X direction.

The alignment mechanism corresponding to the third transmit coil 3 may also include a support rod, which is denoted as D9. The support rod D9 is disposed in parallel with the first screw rod S5. The support rod D9 is configured to support the first guide rod D7, so that the first guide rod D7 runs more smoothly along the X direction.

It can be learned from FIG. 3 that a center alignment region formed by the first transmit coil 1 is 10.

Similarly, a center alignment region formed by the second transmit coil is 20.

A center alignment region formed by the third transmit coil 3 is 30.

In an implementation, a transmit coil may be supported by a support slider and a tray. The support slider is movable, the tray is disposed on the support slider, and the tray may be fixed to the support slider, in other words, the tray may move along with the support slider. The transmit coil is placed on the tray, so that the support slider moves and drives the transmit coil to move. When a center of the support slider is aligned with a center of the transmit coil, a center alignment region of the support slider is a center alignment region of the corresponding transmit coil. When a location of the center of the support slider deviates from a location of the center of the transmit coil, the center alignment region of the support slider also deviates from the center alignment region of the corresponding transmit coil. The foregoing two arrangements are both intended to form the center alignment region of the transmit coil, so that the wireless charging device provided in this embodiment of this application controls the transmit coil to be aligned with a receive coil of an electronic device, to wirelessly charge the electronic device.

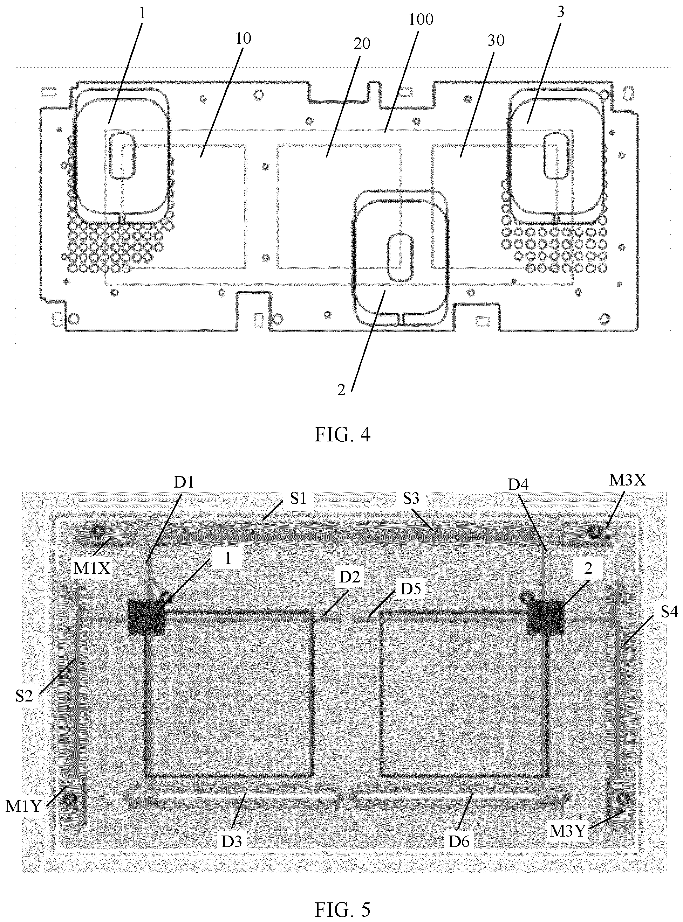

FIG. 4 is a schematic diagram of a plurality of transmit coils that corresponds to FIG. 3.

An example in which the wireless charging device includes three transmit coils is still used for description. The three transmit coils are a first transmit coil 1, a second transmit coil 2, and a third transmit coil 3.

A center alignment region corresponding to the first transmit coil 1 is 10. A center alignment region corresponding to the second transmit coil 2 is 20. A center alignment region corresponding to the third transmit coil 3 is 30.

In FIG. 4, the first transmit coil 1 is located in an upper left corner of the corresponding center alignment region 10, the second transmit coil 2 is located in a lower right corner of the corresponding center alignment region 20, and the third transmit coil 3 is located in an upper right corner of the corresponding center alignment region.

Although there is a spacing between the three center alignment regions, there is no spacing between charging regions formed by the three transmit coils, because a range of a charging region corresponding to a transmit coil is larger than a center alignment region corresponding to the transmit coil. A deviation between a center region of a transmit coil and a center region of a receive coil is within a specific range, for example, 10 mm, and electric energy may be further transmitted, to perform wireless charging.

The wireless charging device described in the foregoing embodiment is described by using three transmit coils as an example. The technical solution provided in this embodiment of this application is also applicable to a case in which the wireless charging device includes two transmit coils. The following provides descriptions with reference to the accompanying drawings.

FIG. 5 is a schematic diagram of another wireless charging device according to an embodiment of this application.

A difference between FIG. 5 and FIG. 3 lies only in that one transmit coil is omitted. Because FIG. 5 shows two transmit coils, two adjacent transmit coils do not need to be arranged in a staggered manner, and may be arranged symmetrically side by side.

It can be learned from FIG. 5 that a first screw rod S1 corresponding to a first transmit coil 1 and a second screw rod S4 corresponding to a second transmit coil 2 are on one straight line, and are not arranged in a staggered manner. Similarly, a second guide rod D2 corresponding to the first transmit coil 1 and a second guide rod DS corresponding to the second transmit coil 2 are also on one straight line, and are not arranged in a staggered manner. However, a second screw rod S2 corresponding to the first transmit coil 1 and the second screw rod S4 corresponding to the second transmit coil 2 are symmetrically distributed on outer sides of the first transmit coil 1 and the second transmit coil 2 respectively.

In addition, a difference between FIG. 5 and FIG. 3 further includes that a support rod D3 corresponding to the first transmit coil 1 and a support rod D6 corresponding to the second transmit coil 2 are located on one side, in other words, on one straight line, but are not symmetrically distributed on two sides of a charging region.

In FIG. 3, the alignment mechanism corresponding to the first transmit coil 1 and the alignment mechanism corresponding to the second transmit coil 2 are arranged in a staggered manner to reduce an area occupied by all the alignment mechanisms at presence of the third transmit coil 3. However, FIG. 5 includes only two transmit coils, and therefore the transmit coils may be arranged side by side, but not in a staggered manner.

When all alignment mechanisms corresponding to all transmit coils are located on one plane, for example, when the wireless charging device is of a flat type, and when the wireless charging device is laid flat on a desktop, three alignment mechanisms corresponding to three transmit coils are at a same vertical height, where a vertical direction is a direction perpendicular to the desktop. When the three alignment mechanisms are located at a same height in the vertical direction, there is a spacing between center alignment regions corresponding to the three transmit coils. Therefore, two adjacent alignment mechanisms are independent of each other and cannot be seamlessly connected. However, charging regions corresponding to the three transmit coils can be seamlessly connected without a spacing.

To ensure that there is no spacing between center alignment regions corresponding to alignment mechanisms corresponding to fixed motors, a middle alignment mechanism may be moved down to another plane. To be specific, a height of the middle alignment mechanism in a vertical direction is lower than those of two alignment mechanisms on two sides.

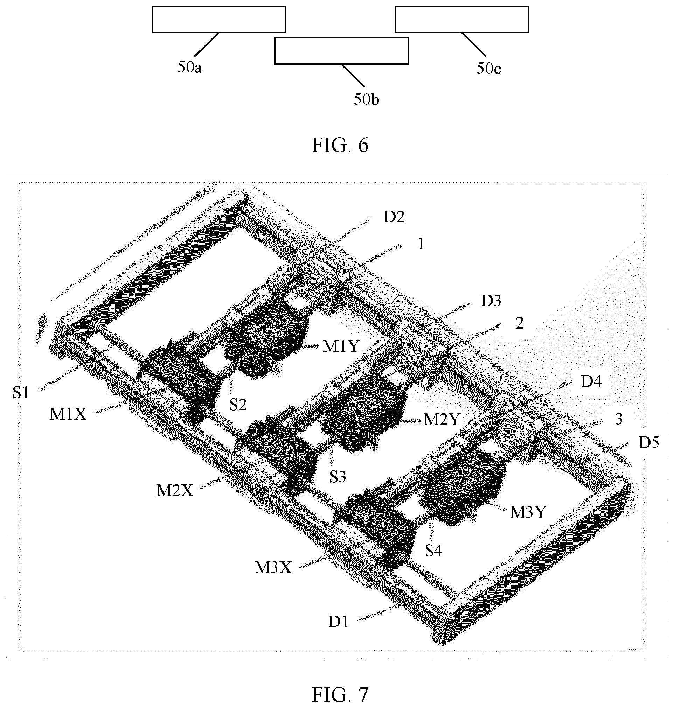

FIG. 6 is a side view of three alignment mechanisms according to an embodiment of this application.

This embodiment is still described by using an example in which the wireless charging device includes three transmit coils.

At least three transmit coils are included, and alignment mechanisms corresponding to the three transmit coils are a first alignment mechanism 50a, a second alignment mechanism 50b, and a third alignment mechanism 50c.

The first alignment mechanism 50a, the second alignment mechanism 50b, and the third alignment mechanism 50c are sequentially arranged along a first direction (an X direction).

Both the first alignment mechanism 50a and the third alignment mechanism 50c are at a first height in a vertical direction.

The second alignment mechanism 50b is at a second height in the vertical direction. The first height and the second height are different heights. In other words, projections of the first alignment mechanism 50a and the second alignment mechanism 50b in the vertical direction do not overlap. Whether the first height is higher or the second height is higher is not limited in this embodiment of this application. In FIG. 6, the first height is higher than the second height. It should be understood that the second height may be alternatively higher than the first height.

Because the second alignment mechanism 50b and the first alignment mechanism 50a are not at a same height in the vertical direction, the second alignment mechanism 50b and the first alignment mechanism 50a may cross in a horizontal direction, in other words, projections in the horizontal direction may partially overlap. In this way, a spacing between a center alignment region of a first transmit coil and a center alignment region of a second transmit coil can be eliminated, so that center alignment regions corresponding to the three transmit coils can be seamlessly connected.

It should be understood that a spacing between center alignment ranges corresponding to two adjacent transmit coils is reduced or eliminated through varying heights of the alignment mechanisms in the vertical direction. In other words, there may be no spacing, or there may still be a spacing. This is not specifically limited in this embodiment of this application.

FIG. 6 is described by using an example in which the wireless charging device includes three transmit coils. To avoid a spacing between center alignment regions corresponding to two adjacent transmit coils, one of two adjacent alignment mechanisms may be moved down to a next layer in the vertical direction. Similarly, the manner shown in FIG. 5 is also applicable to a case in which the wireless charging device includes two transmit coils. To be specific, for alignment mechanisms corresponding to the two transmit coils shown in FIG. 5, one of the alignment mechanisms may be moved down to another height, to reduce or eliminate a spacing between center alignment regions of two adjacent transmit coils through varying heights in the vertical direction.

In the foregoing stacked arrangement of the alignment mechanisms, there can be no spacing between center alignment regions corresponding to two adjacent transmit coils. In terms of a charging effect, when a spacing between center alignment regions corresponding to two adjacent transmit coils is ≤ 8 mm, a charging effect for an electronic device at any location is not affected; or when a spacing between center alignment regions corresponding to two adjacent transmit coils is ≥ 8 mm, and when an electronic device is placed at a middle location, that is, in the spacing, between the center alignment regions corresponding to the two adjacent transmit coils and the wireless charging device wirelessly charges the electronic device in the spacing, charging efficiency is significantly lower than charging efficiency in the center alignment regions. Therefore, in this embodiment of this application, to improve charging efficiency, the alignment mechanisms are stacked, so that center alignment regions of the transmit coils can be contiguous, to implement efficient wireless charging for the entire plane, and implement real place-and-charge.

An alignment mechanism corresponding to the fixed motor provided in this embodiment of this application may limit a movement range of a support slider through mechanical limiting or controlled limiting by a controller, so that a charging region corresponding to each transmit coil is an independent range, to avoid spatial interference between transmit coils.

A plurality of transmit coils jointly form a sufficiently large charging range, and each transmit coil is responsible for wirelessly charging only an electronic device placed within an independent charging range of the transmit coil. A groove may be provided on an outer surface of an upper housing of the wireless charging device, to limit or indicate a charging region corresponding to a transmit coil. An electronic device with a relatively small size may be placed in the groove, and an electronic device with a relatively large size may be placed on the groove, to avoid the following problem: When a size of an electronic device is smaller than a size of a transmit coil, a user places two electronic devices with relatively small sizes within a size range of one transmit coil. As a result, one of the electronic devices cannot be charged.

### Device Embodiment 3

In the wireless charging device described in the foregoing embodiments, each motor is fastened at an end of a screw rod and cannot move. The following describes an implementation in which a motor can move along a screw rod. First, an implementation in which the wireless charging device includes three transmit coils is described with reference to the accompanying drawings. It should be understood that a specific quantity of transmit coils in a corresponding wireless charging device driven by a motor is not limited, and may be greater than or equal to 2. When the wireless charging device provided in this embodiment of this application includes a movable motor, projections of center alignment regions corresponding to transmit coils may overlap, or may not overlap.

In a wireless charging device in which a motor is movable, an alignment mechanism includes N first motors, N second motors, one first screw rod, and N second screw rods. All the second screw rods are perpendicular to the first screw rod. N is a quantity of at least two transmit coils, and N is an integer greater than or equal to 2.

All the N first motors are movably sleeved on the first screw rod. The alignment mechanism includes only one first screw rod, and all the first motors share the same first screw rod. Because all the first motors are located on the same screw rod, a movement range of each first motor may fully cover a length of the first screw rod. This is different from the fixed motor provided in the foregoing embodiment. FIG. 3 is still used as an example. When the alignment mechanisms corresponding to the three transmit coils are located at one layer, because the screw rods corresponding to the fixed motors are independent of each other, and the screw rods are not seamlessly connected, this is equivalent to that there is an obstacle between two adjacent first motors, and there is a spacing between center alignment regions corresponding to two adjacent transmit coils. However, in this embodiment, because the three first motors share the same screw rod, movement ranges of the three first motors may be seamlessly connected on the first screw rod, so that there is no spacing between center alignment regions corresponding to the three transmit coils. In other words, there is no intersection between movement ranges on the first screw rod that respectively correspond to the N first motors. Alternatively, there may be an intersection between movement ranges on the first screw rod that respectively correspond to the N first motors.

The N second motors are in a one-to-one correspondence with the N second screw rods, and each second motor is movably sleeved on a corresponding second screw rod. A corresponding transmit coil is placed on each second motor. When the second motor moves, the transmit coil located on the second motor may be driven to move along a Y direction. A tray may be disposed on each second motor, and the tray is used for placing a transmit coil. The transmit coil may be fixed to the tray. Whether heights of trays are a same height or different heights is not limited in this embodiment of this application. In addition, a connection relationship between the tray and the second motor may be of a fixed type, or a height of the tray may be adjustable, to adjust a height of the transmit coil.

In addition, a slider may be further disposed on the second motor, and the tray is disposed on the slider. A center of the slider and a center of the tray may be aligned, or may deviate from each other, to be specific, there is a deviation between projections of the center of the slider and the center of the tray on a horizontal plane. When the center of the slider and the center of the tray deviate from each other, avoidance between adjacent motors, screw rods, and guide rods can be avoided, to prevent mutual interference.

Each second screw rod is fixed to a corresponding first motor. Specifically, the second screw rod may be fixed to the corresponding first motor by adding a mechanical part or through laser welding. In this case, when the first motor moves, the second screw rod is driven to move. However, because the first motor needs to move along the first screw rod, a connection relationship between the first motor and the first screw rod is of a penetrating type.

In the wireless charging device provided in this embodiment of this application, all motors may move along a screw rod, but are not fixed to the screw rod or non-movable.

The alignment mechanism further includes one first guide rod and N second guide rods. The first guide rod is disposed in parallel with the first screw rod, and the N second guide rods are disposed in parallel with the N second screw rods respectively. All the first motors are movably sleeved on the first guide rod. Each second motor is movably sleeved on a corresponding second guide rod.

The alignment mechanism further includes a third guide rod disposed in parallel with the first guide rod. N sliders are disposed on the third guide rod. The second screw rods and the second guide rods each are connected to a corresponding slider.

The alignment mechanism further includes N trays. A tray is disposed on each second motor, and the tray is configured to carry a transmit coil. Heights of the trays are adjustable, so that different transmit coils are on different planes.

The following describes an alignment mechanism corresponding to a movable motor with reference to FIG. 7 still by using an example in which the wireless charging device includes three transmit coils.

FIG. 7 is a three-dimensional diagram of another wireless charging device according to an embodiment of this application.

The wireless charging device provided in this embodiment includes three transmit coils: a first transmit coil 1, a second transmit coil 2, and a third transmit coil 3.

The first transmit coil 1 corresponds to a first motor M1X and a second motor M1 Y. The second transmit coil 2 corresponds to a first motor M2X and a second motor M2Y. The third transmit coil 3 corresponds to a first motor M3X and a second motor M3Y

The three first motors M1X, M2X, and M3X are all sleeved on a first screw rod S1, and may move along the first screw rod S1 in an X direction, to change a location of a transmit coil in the X direction accordingly.

The second motor M1Y corresponding to the first transmit coil 1 is sleeved on a second screw rod S2. The second motor M2 corresponding to the second transmit coil 2 is sleeved on a second screw rod S3. The second motor M3 corresponding to the third transmit coil 3 is sleeved on a second screw rod S4.

To perform a support function and enable a motor to run more stably along a screw rod, in addition to being sleeved on a screw rod, each motor may be further clamped on a guide rod, and the guide rod performs a support function. As shown in FIG. 7, the alignment mechanism further includes a first guide rod D1, a second guide rod D2, a third guide rod D3, and a fourth guide rod D4. The three first motors M1X, M2X, and M3X are all clamped on the first guide rod D1, the first guide rod D1 is disposed in parallel with the first screw rod S1, and both ends of the first guide rod D1 and the first screw rod S1 are fixed to a bracket. The three second motors M1Y, M2Y, and M3Y are clamped on the three second guide rods D2, D3, and D4 respectively. The three second guide rods D2, D3, and D4 are disposed in parallel with the corresponding three second screw rods S2, S3, and S4 respectively.

In addition, to fix a second screw rod to a second guide rod, the alignment mechanism provided in this embodiment may further include a third guide rod DS disposed in parallel with the first guide rod D1. N sliders are disposed on the third guide rod D5. The second screw rods and the second guide rods each are connected to a corresponding slider. For example, a first end of the second screw rod S2 is fixed to the first motor M1X, a second end of the second screw rod S2 is fixed to a slider disposed on the third guide rod D5, a first end of the second guide rod D2 is fixed to the first motor M1X, and a second end of the second guide rod D2 is fixed to a slider disposed on the third guide rod D5. Connections between the other second screw rods and second guide rods are similar, and are not described herein again.

It can be learned from the foregoing analysis that the first motor M1X and the second motor M1Y are configured to drive the first transmit coil 1 to move in the X direction and a Y direction respectively. The first motor M2X and the second motor M2Y are configured to drive the second transmit coil 2 to move in the X direction and the Y direction respectively. The first motor M3X and the second motor M3Y are configured to drive the third transmit coil 3 to move in the X direction and the Y direction respectively.

If two motors corresponding to each transmit coil are located at a vertex of a corresponding region, for example, in a lower left corner or an upper right corner, the transmit coil may move to cover an area of an entire rectangle.

The foregoing describes the movement manners of the three transmit coils. The following describes an implementation corresponding to a case in which the wireless charging device includes two transmit coils.

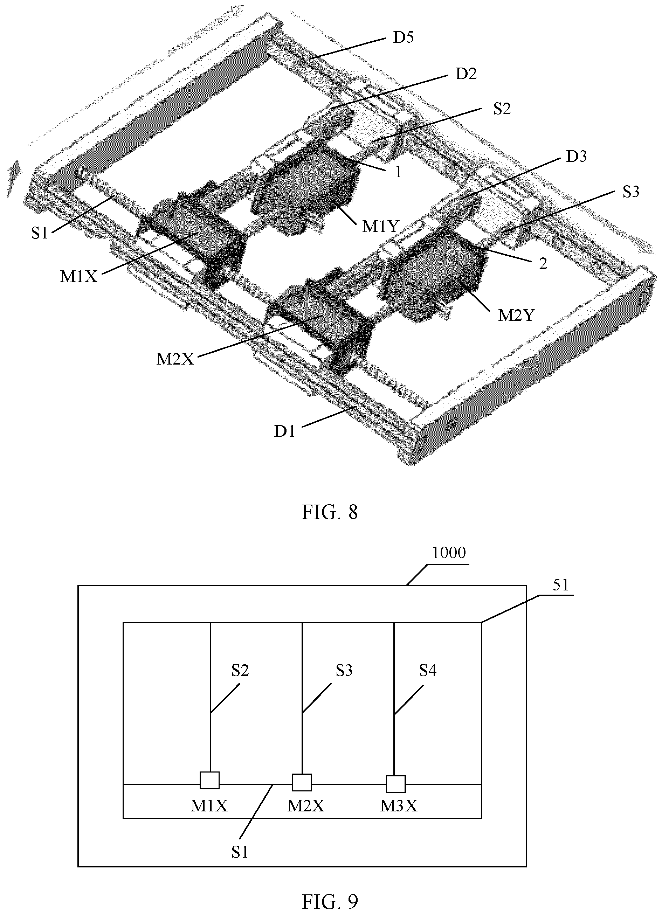

FIG. 8 is a schematic diagram of still another wireless charging device according to an embodiment of this application.

A difference between the wireless charging device provided in this embodiment and that in FIG. 7 lies only in that one transmit coil is omitted. Therefore, one first motor and one second motor are omitted, and one second screw rod and one second guide rod are omitted.

The rest is the same as that in FIG. 7, and details are not described herein again.

The following describes an operating principle of alignment of a transmit coil corresponding to the movable motor shown in FIG. 7 and FIG. 8 with reference to a simplified diagram of FIG. 9.

FIG. 9 is a simplified diagram corresponding to FIG. 7.

The alignment mechanism included in the wireless charging device 1000 shown in FIG. 9 includes a frame 51, and all screw rods and guide rods are fixed to the frame 51. The following describes only a case of movement of the first motor. Different movement manners of the first motor affect a corresponding center alignment region.

A motor included in the wireless charging device may be movable. Based on different motion manners of the motor, to be specific, a controller controls different movement manners of the motor, there may be two forms: In a first form, there is a spacing between projections of center alignment regions corresponding to transmit coils. In a second form, there is no spacing between projections of center alignment regions corresponding to transmit coils. However, in both of the foregoing forms, there can be no spacing between projections of charging regions corresponding to transmit coils, in other words, charging can be performed on an entire contiguous plane.

The following first describes a first movement manner. It should be understood that a common point between two movement manners lies in that each of three second motors may move within an entire length of a second screw rod corresponding to the second motor. A difference between the two movement manners lies in that movement ranges of three first motors along a first screw rod vary.

### Manner 1:

The three first motors each have a fixed movement range.

The three first motors M1X, M2X, and M3X evenly share a length of the first screw rod S1. Each first motor moves within a range of one third of the length of the first screw rod S1. For example, when the first motor M1X moves along the first screw rod S1, the first motor M1X does not enter a movement range of the first motor M2X. Similarly, when the first motor M3X moves, the first motor M3X does not enter a movement range of the first motor M1X.

Because the first motors each move on the first screw rod S1 within a corresponding distance, when a first motor and a second motor jointly drive a transmit coil to move, center alignment regions corresponding to transmit coils are independent of each other, and do not cross. There may be a spacing between the center alignment regions. This is similar to the case of the center alignment regions corresponding to the fixed motors shown in FIG. 3. An only difference lies in that all the three first motors in this embodiment are on the first screw rod S1, and there is no other obstacle except that sizes of the first motors affect the center alignment regions.

In the first movement manner described above, there may be a spacing between center alignment regions formed by the three transmit coils. Still refer to the relationship between a charging region and a center alignment region in FIG. 3. Details are not described herein again.

### Manner 2:

None of the three first motors has a fixed movement range.

Different from the first manner, in the second movement manner, each first motor may move within a long distance range on the first screw rod S1, in other words, none of the first motors has a fixed movement region. For example, the first motor M1X may move to a location of the first motor M2X in FIG. 9, and the first motor M3X may move to a location of the first motor M1X.

Because each first motor can move within a large range, a center alignment region corresponding to each transmit coil is larger than the center alignment region in the first manner.

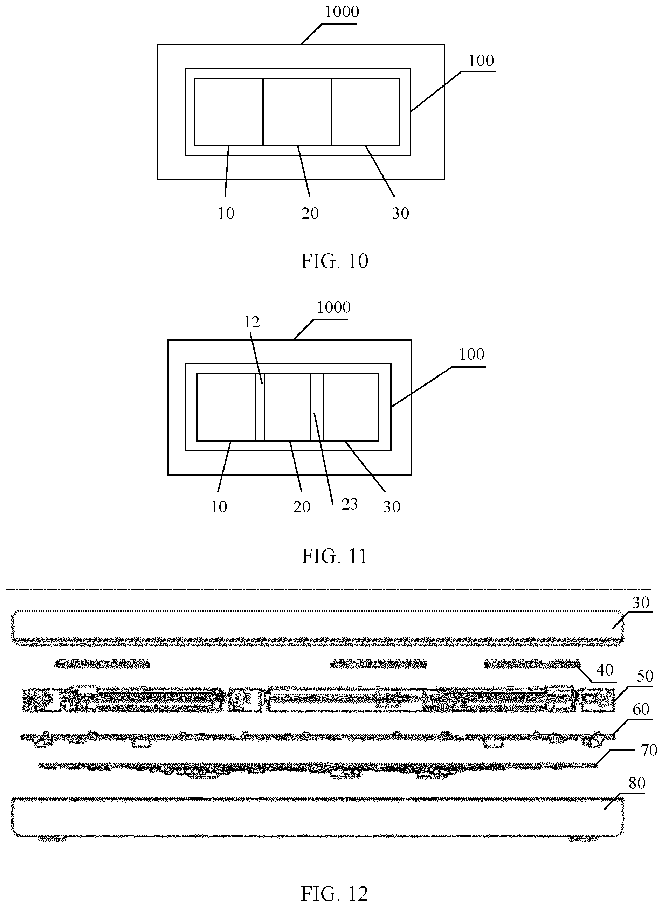

In the second movement manner described above, projections of center alignment regions formed by the three transmit coils may have no spacing in between, in other words, are seamlessly connected. It can be understood that, because a charging region formed by a transmit coil is larger than a center alignment region, when there is no spacing between the projections of the center alignment regions corresponding to the three transmit coils, projections of charging regions formed by the three transmit coils overlap. For example, FIG. 10 is a schematic diagram in which there is no spacing between projections of charging regions formed by three transmit coils. To be specific, projections of a charging region 10, a charging region 20, and a charging region 30 are seamlessly connected.

Alternatively, in the second movement manner, the projections of the center alignment regions formed by the three transmit coils may overlap. FIG. 11 is a schematic diagram in which projections of center alignment regions corresponding to three transmit coils overlap according to an embodiment of this application.

There is an overlapping region 12 between projections of a center alignment region 10 corresponding to a first transmit coil and a center alignment region 20 corresponding to a second transmit coil. Similarly, there is an overlapping region 23 between projections of the center alignment region 20 corresponding to the second transmit coil and a center alignment region 30 corresponding to a third transmit coil. There is an overlapping region between projections of center alignment regions corresponding to two adjacent transmit coils of the three transmit coils. Therefore, there is also an overlapping region between projections of charging regions corresponding to the two adjacent transmit coils. When charging an electronic device, the wireless charging device may select a transmit coil corresponding to the electronic device to charge the electronic device. When a plurality of electronic devices are wirelessly charged, movable motors may be alternatively used, so that projections of charging regions of transmit coils do not overlap.

In the wireless charging device provided in this embodiment of this application, because a transmit coil may be aligned with a receive coil and the transmit coil is responsible for charging only the aligned receive coil, efficient charging can be implemented, and fast charging with a relatively large power can be implemented. For example, a wireless charging power of 27 W or above may be provided.

Embodiment 2 and Embodiment 3 respectively describe the wireless charging device corresponding to the fixed motor and the wireless charging device corresponding to the movable motor. The following describes other layouts applicable to the foregoing two wireless charging devices.

FIG. 12 is an exploded view of a wireless charging device according to an embodiment of this application.

The exploded view shown in FIG. 12 is a side view of the wireless charging device provided in this embodiment of this application.

In addition to a transmit coil and an alignment mechanism 50, the wireless charging device provided in this embodiment of this application may further include an upper housing 30, a tray 40, a bracket 60, a circuit board 70, and a lower housing 80.

The circuit board 70 includes a controller and a peripheral circuit. The controller is configured to control the alignment mechanism to drive the transmit coil to move.

In this embodiment of this application, a location relationship between the circuit board 70 and the alignment mechanism 50 is not limited. To make the entire wireless charging device thinner, alignment mechanisms corresponding to all transmit coils may be located at one layer. This can reduce a thickness of the wireless charging device, and facilitate heat dissipation for the circuit board 70 and the transmit coils.

The alignment mechanism 50 may be located on the bracket 60, and the bracket 60 is configured to support the alignment mechanism 50.

The wireless charging device provided in this embodiment of this application may further include the lower housing 80. The upper housing 30 and the lower housing 80 fit each other, to package the tray 40, the alignment mechanism 50, the bracket 60, and the circuit board 70 inside.

In this embodiment of this application, a location relationship between the alignment mechanism 50 and the circuit board 70 is not limited either. FIG. 12 is described by using an example in which the alignment mechanism 50 and the circuit board 70 are stacked in a vertical direction, in other words, the alignment mechanism 50 is located directly above the circuit board 70. The vertical direction is a direction perpendicular to a charging plane.

The following describes another implementation. To make the wireless charging device thinner, the alignment mechanism and the circuit board may be located at one layer.

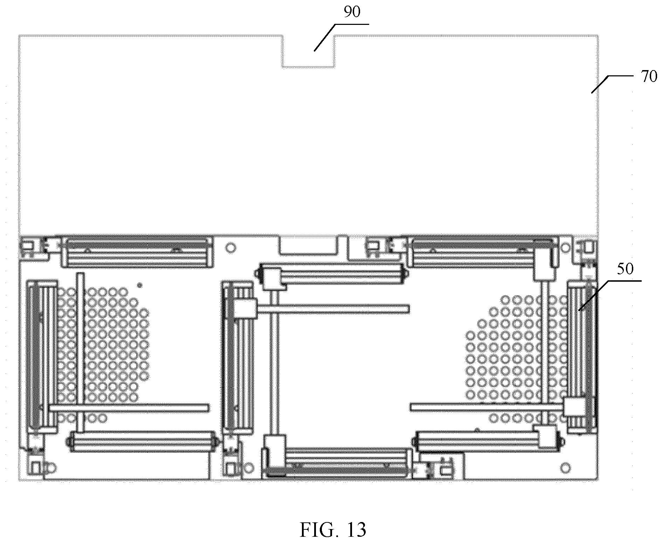

FIG. 13 is a schematic diagram in which an alignment mechanism and a circuit board are arranged side by side according to an embodiment of this application.

During specific implementation, the alignment mechanism 50 and the circuit board 70 may be arranged side by side at one layer, in other words, are arranged side by side on one horizontal plane. This can reduce a thickness of the wireless charging device in the vertical direction, so that the entire wireless charging device is made thinner, thereby facilitating heat dissipation.

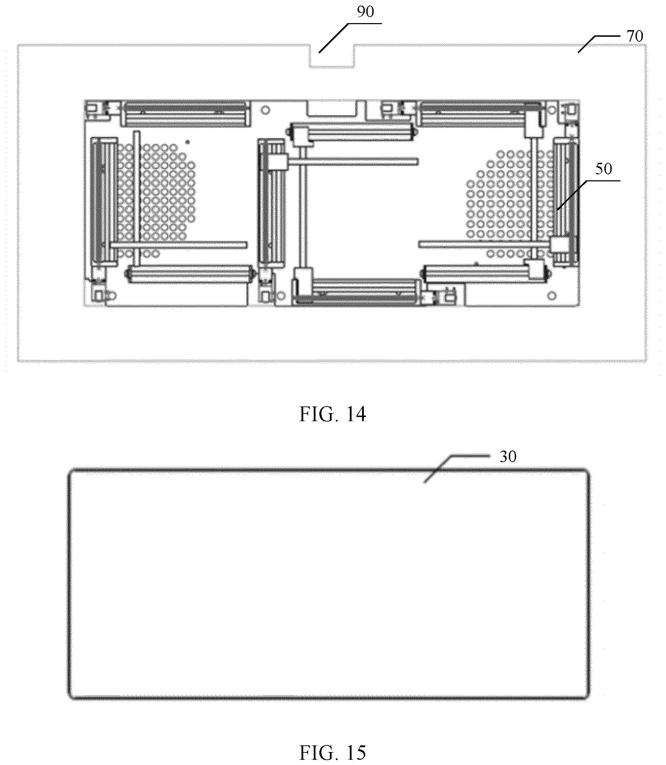

FIG. 14 is a schematic diagram in which a circuit board surrounds an alignment mechanism according to an embodiment of this application.

In the wireless charging device provided in this embodiment, the circuit board 70 may surround a periphery of the alignment mechanism 50, in other words, the circuit board 70 and the alignment mechanism 50 are arranged side by side on one horizontal plane. This can reduce a thickness of the wireless charging device in the vertical direction, so that the entire wireless charging device is made thinner, thereby facilitating heat dissipation.

In this embodiment of this application, a specific layout form is not specifically limited when the circuit board 70 and the alignment mechanism 50 are located at one layer. Any one of the foregoing two forms may be used, or a co-layer layout in another form may be used.

The following describes a specific implementation of the upper housing 30 of the wireless charging device provided in this embodiment of this application with reference to the accompanying drawings. First, a first implementation is described.

FIG. 15 is a top view of an upper housing according to an embodiment of this application.

In an implementation, there is no groove on an outer surface of the upper housing 30 of the wireless charging device, in other words, the outer surface is a flat plane. In this way, an appearance is more appealing, and a manufacturing process is simple, thereby facilitating manufacturing.

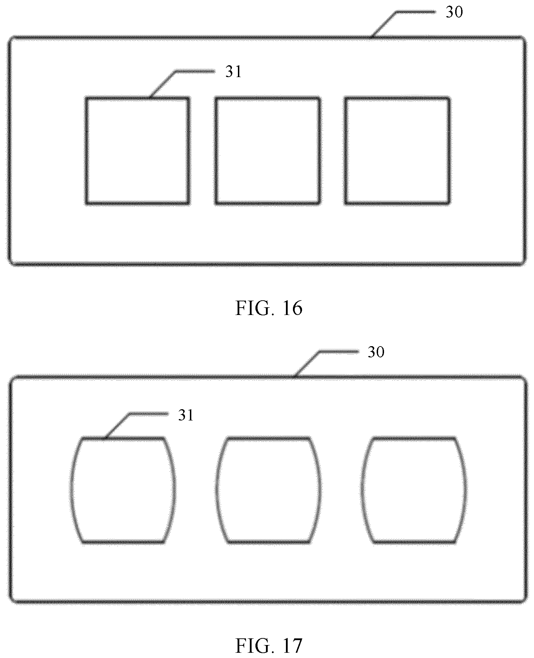

FIG. 16 is a top view of another upper housing according to an embodiment of this application.

In another implementation, a groove is provided on an outer surface of the upper housing 30 of the wireless charging device. A quantity of grooves is not specifically limited in this embodiment of this application, and may be equal to a quantity of transmit coils. For example, when the wireless charging device includes three transmit coils, the quantity of grooves is also 3.

A groove shown in FIG. 16 is a square groove, and may be alternatively a rectangular groove.

Sizes of grooves may be the same.

For an electronic device whose size is greater than a size of a groove, for example, a mobile phone, the groove is configured to indicate a location at which the mobile phone is to be placed. For an electronic device whose size is less than or equal to a size of a groove, for example, a headset case or a watch, the groove may limit a location at which the headset case or the watch is to be placed.

FIG. 17 is a top view of still another upper housing according to an embodiment of this application.

A groove shown in FIG. 17 is a non-square groove.

It should be understood that a specific shape of the groove may be of a type other than those shown in FIG. 16 and FIG. 17. This is not specifically limited in this embodiment of this application. For example, the groove may be in a circular shape or an elliptic shape. Alternatively, sizes of grooves may be different.

In the wireless charging device provided in the foregoing embodiments of this application, sizes of transmit coils may be the same, in other words, a type of an electronic device is not limited, and the electronic device may be placed at a location corresponding to any transmit coil for charging.

The following describes heat dissipation of the wireless charging device provided in embodiments of this application with reference to the accompanying drawings.

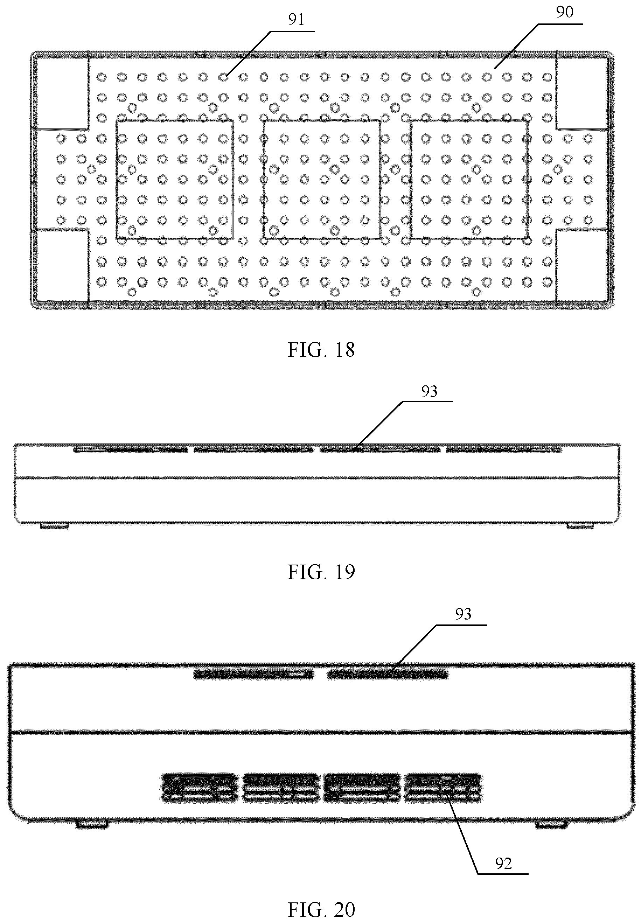

FIG. 18 is a schematic diagram of a heat dissipation part according to an embodiment of this application.

The wireless charging device provided in this embodiment includes a sandwich-like heat dissipation apparatus, including three parts: an upper housing 30, a flat plate 90, and a hollow layer located between the upper housing 30 and the flat plate 90.

The flat plate 90 is disposed directly under the upper housing 30, and the upper housing 30 is disposed in parallel with the flat plate 90.

An air vent 91 is provided on the flat plate 90.

A gap layer is provided between the upper housing 30 and the flat plate 90.

FIG. 18 is a top view of the heat dissipation part. To describe a structure of the heat dissipation part more clearly, the following provides further descriptions with reference to side views in two directions.

FIG. 19 is a side view of a heat dissipation part of a wireless charging device according to an embodiment of this application.

FIG. 20 is a side view of an adjacent side surface corresponding to FIG. 19 according to an embodiment of this application.

An air intake vent 93 is provided at a location, on a side surface of the wireless charging device, that corresponds to the gap layer.

Cold air enters the gap layer through the air intake vent 93, and enters an inner cavity of the wireless charging device through the air vent 91 on the flat plate 90, to dissipate heat for a transmit coil.

In addition, an air outlet 92 is further provided on a side surface of the wireless charging device, and airflow in the inner cavity of the wireless charging device is blown out of the air outlet 92.

It should be understood that a fan is disposed in the wireless charging device, to speed up airflow circulation and improve a heat dissipation capability.

The wireless charging device is a one-to-many wireless charging device. Therefore, when the wireless charging device simultaneously wirelessly charge a plurality of electronic devices, heat needs to be dissipated for the wireless charging device through air cooling. In addition, the air duct further needs to be in effective contact with an upper surface of an upper cover, to ensure a sufficiently low temperature rise on the upper surface of the wireless charging device, and help an electronic device dissipate heat during charging. Therefore, the upper housing of the one-to-many wireless charging device is designed by using a sandwich structure, and the air intake vent 93 is used for air intake. The air intake vent 93 is in full contact with an upper surface of the upper housing 30, to ensure a sufficiently low temperature rise on the upper surface of the wireless charging device, and help an electronic device dissipate heat during charging. With the air vent 91 on the flat plate 90, the air duct for entering the inner cavity of the wireless charging device can be optimized. The optimized air duct can prevent cold air from being directly sucked in and blown out by fans on two sides and failing to dissipate heat for a transmit coil located in a center.

In addition, the wireless charging device provided in this embodiment of this application may further include a controller.

The controller controls an alignment mechanism to drive transmit coils of N transmit coils to be respectively aligned with receive coils of different receiving devices of at least two electronic devices. A manner of controlling the alignment mechanism by the controller is not specifically limited in this embodiment of this application. For example, the controller may obtain a location of a receive coil, and control a transmit coil to move to be aligned with the receive coil in an electronic device.

Based on the wireless charging device provided in the foregoing embodiment, an embodiment of this application further provides a wireless charging base. The wireless charging base is configured to wirelessly charge at least two electronic devices, and includes a power interface, an upper cover, a lower cover, an alignment mechanism, and at least two transmit coils. The alignment mechanism and the at least two transmit coils are located in a cavity formed by the upper cover and the lower cover. The power interface is disposed on a side of the cavity. The power interface is configured to connect a direct current transmitted by an adapter. The transmit coils are in a one-to-one correspondence with the electronic devices. Each of the at least two transmit coils forms a corresponding charging region on a charging plane. Charging regions corresponding to two adjacent transmit coils are interconnected or overlap, in other words, the charging regions are contiguous without a spacing. The charging plane is located on a surface, of surfaces of the wireless charging device, that is used for placing the electronic device. The alignment mechanism is configured to drive transmit coils of the at least two transmit coils to be respectively aligned with receive coils of different receiving devices of the at least two electronic devices, so that the transmit coils wirelessly charge the corresponding electronic devices.

The wireless charging base provided in this embodiment of this application is a one-to-many base, in other words, the wireless charging base may simultaneously charge a plurality of electronic devices. The adapter may be connected to the power interface of the wireless charging base, and the adapter is configured to convert an alternating current into a direct current, and supply the direct current to the wireless charging base. The wireless charging base converts the direct current and then wirelessly charges the electronic devices. The transmit coils in the wireless charging base may move to be aligned with receive coils in the electronic devices, thereby implementing place-and-charge. In addition, because there is no spacing between charging regions corresponding to transmit coils, an entire plane of the base may serve as a charging region for charging the electronic devices, thereby improving charging efficiency.

The at least two transmit coils may be N transmit coils, and the N transmit coils simultaneously wirelessly charge N different electronic devices.

For an implementation of an alignment mechanism corresponding to each transmit coil, refer to the descriptions in the foregoing device embodiments. Details are not described herein again.

It should be understood that, in this application, "at least one piece (item)" means one or more, and "a plurality of" means two or more. The term "and/or" is used to describe an association relationship between associated objects, and indicates that three relationships may exist. For example, "A and/or B" may indicate the following three cases: Only A exists, only B exists, and both A and B exist, where A and B may be singular or plural. The character "/" generally indicates an "or" relationship between the associated objects. "At least one of the following items (pieces)" or a similar expression thereof indicates any combination of these items, including a single item (piece) or any combination of a plurality of items (pieces). For example, at least one item (piece) of a, b, or c may represent: a, b, c, "a and b", "a and c", "b and c", or "a, b, and c", where a, b, and c may be singular or plural.

The foregoing embodiments are merely intended to describe the technical solutions of this application, but not to limit this application. Although this application is described in detail with reference to the foregoing embodiments, a person of ordinary skill in the art should understand that they may still make modifications to the technical solutions described in the foregoing embodiments or make equivalent replacements to some technical features thereof, without departing from the spirit and scope of the technical solutions of embodiments of this application.

## Claims

1. A wireless charging device, wherein the wireless charging device is configured to wirelessly charge at least two electronic devices, and the wireless charging device comprises an alignment mechanism and at least two transmit coils;
the at least two transmit coils are in a one-to-one correspondence with the at least two electronic devices, and each transmit coil is configured to wirelessly charge a corresponding electronic device;
each of the at least two transmit coils forms a corresponding charging region on a charging plane, charging regions corresponding to two adjacent transmit coils are interconnected or overlap, and the charging plane is located on a surface, of surfaces of the wireless charging device, that is used for placing the electronic device; and
the alignment mechanism is configured to drive transmit coils of the at least two transmit coils to be respectively aligned with receive coils of different receiving devices of the at least two electronic devices, so that the transmit coils wirelessly charge the corresponding electronic devices.

2. The device according to claim 1, wherein projections, on the charging plane, of center alignment regions corresponding to two adjacent transmit coils of the at least two transmit coils do not overlap, and the center alignment regions are regions in which centers of the at least two transmit coils may be respectively aligned with centers of receive coils of different receiving devices of the corresponding at least two electronic devices.

3. The device according to claim 1, wherein projections, on the charging plane, of center alignment regions corresponding to two adjacent transmit coils of the at least two transmit coils overlap, and the center alignment regions are regions in which centers of the at least two transmit coils may be respectively aligned with centers of receive coils of different receiving devices of the corresponding at least two electronic devices.

4. The device according to any one of claims 1 to 3, comprising at least two alignment mechanisms, wherein the at least two transmit coils are in a one-to-one correspondence with the at least two alignment mechanisms;
each alignment mechanism comprises a first motor and a second motor;
the first motor is configured to drive a corresponding transmit coil to move along a first direction;
the second motor is configured to drive a corresponding transmit coil to move along a second direction; and
the first direction is perpendicular to the second direction.

5. The device according to claim 4, wherein each alignment mechanism further comprises a first guide rod, a second guide rod, a first screw rod, a second screw rod, and a coil support slider;
the first screw rod and the second screw rod are perpendicular to each other, the first guide rod and the second guide rod are perpendicular to each other, the first screw rod is disposed along the first direction, and the second screw rod is disposed along the second direction;
the coil support slider is sleeved at a junction between the first guide rod and the second guide rod, and the coil support slider is configured to support a corresponding transmit coil;
the first motor is fastened at an end of the first screw rod, the first guide rod is sleeved on the first screw rod, and the first motor drives the first guide rod to move along the first screw rod; and
the second motor is fastened at an end of the second screw rod, the second guide rod is sleeved on the second screw rod, and the second motor drives the second guide rod to move along the second screw rod.

6. The device according to claim 5, wherein each alignment mechanism further comprises a support rod;
for each alignment mechanism, the support rod is disposed in parallel with the first screw rod; and
a first end of the first guide rod is sleeved on the first screw rod, and a second end of the first guide rod is sleeved on the support rod.

7. The device according to claim 5 or 6, wherein each alignment mechanism further comprises a tray; and
the tray is disposed on each coil support slider, and the tray is configured to carry a corresponding transmit coil.

8. The device according to any one of claims 4 to 7, wherein the at least two alignment mechanisms are located on one plane.

9. The device according to any one of claims 4 to 7, wherein the at least two transmit coils comprise at least three transmit coils, and the at least two alignment mechanisms comprise at least the following three alignment mechanisms: a first alignment mechanism, a second alignment mechanism, and a third alignment mechanism;
the first alignment mechanism, the second alignment mechanism, and the third alignment mechanism are sequentially arranged along the first direction;
both the first alignment mechanism and the third alignment mechanism are at a first height in a vertical direction;
the second alignment mechanism is at a second height in the vertical direction, and the first height and the second height are different; and
there is no spacing between projections, on the charging plane, of center alignment regions corresponding to two adjacent transmit coils of the at least two transmit coils.

10. The device according to any one of claims 1 to 3, wherein the alignment mechanism comprises N first motors, N second motors, one first screw rod, and N second screw rods, N is a quantity of the at least two transmit coils, and N is an integer greater than or equal to 2;
all the N first motors are movably sleeved on the first screw rod;
the N second motors are in a one-to-one correspondence with the N second screw rods, each second motor is movably sleeved on a corresponding second screw rod, and corresponding transmit coils are respectively placed on the N second motors; and
all the N second screw rods are perpendicular to the first screw rod, the N second screw rods are in a one-to-one correspondence with the N first motors, and each second screw rod is fixed to a corresponding first motor.

11. The device according to claim 10, wherein there is no intersection between movement ranges on the first screw rod that respectively correspond to the first motors.

12. The device according to claim 10, wherein there is an intersection between movement ranges on the first screw rod that respectively correspond to the first motors.

13. The device according to any one of claims 10 to 12, wherein the alignment mechanism further comprises one first guide rod and N second guide rods;
the first guide rod is disposed in parallel with the first screw rod, the N second guide rods are in a one-to-one correspondence with and are disposed in parallel with the N second screw rods, and the N second motors are in a one-to-one correspondence with the N second guide rods;
all the N first motors are movably sleeved on the first guide rod; and
each second motor is movably sleeved on a corresponding second guide rod.

14. The device according to claim 13, wherein the alignment mechanism further comprises a third guide rod disposed in parallel with the first guide rod;
N sliders are disposed on the third guide rod, the N sliders are in a one-to-one correspondence with the N second guide rods, and the N sliders are in a one-to-one correspondence with the N second screw rods; and
the second screw rods and the second guide rods each are connected to a corresponding slider.

15. The device according to any one of claims 10 to 14, wherein the alignment mechanism further comprises N trays, and the N trays are in a one-to-one correspondence with the N second motors; and
each tray is disposed on a corresponding second motor, and each tray is configured to carry a corresponding transmit coil.

16. The device according to claim 5 or 10, wherein a height of the N trays is adjustable, so that the at least two transmit coils are respectively located on different planes.

17. The device according to any one of claims 1 to 16, further comprising a circuit board, wherein
the alignment mechanism and the circuit board are stacked in the vertical direction, and the vertical direction is a direction perpendicular to the charging plane.

18. The device according to any one of claims 1 to 16, further comprising a circuit board, wherein
the circuit board and the alignment mechanism are located at one layer, and the circuit board and the alignment mechanism are arranged side by side.

19. The device according to any one of claims 1 to 16, further comprising a circuit board, wherein
the circuit board and the alignment mechanism are located at one layer, and the circuit board surrounds a periphery of the alignment mechanism.

20. The device according to any one of claims 1 to 19, further comprising an upper housing and a flat plate, wherein
the flat plate is disposed directly under the upper housing, and the upper housing is disposed in parallel with the flat plate;
an air vent is provided on the flat plate;
a gap layer is provided between the upper housing and the flat plate;
an air duct is provided at a location, on a side surface of the wireless charging device, that corresponds to the gap layer; and
cold air enters the gap layer through the air duct, and enters an inner cavity of the wireless charging device through the air vent on the flat plate, to dissipate heat for the transmit coil.

21. The device according to claim 20, wherein N grooves are provided on an outer surface of the upper housing, N is a quantity of transmit coils, and N is an integer greater than or equal to 2; and
the N grooves are configured to limit a location of an electronic device whose size is smaller than a size of the groove, and the groove is further configured to indicate a placement location of an electronic device whose size is greater than the size of the groove during wireless charging.

22. The device according to any one of claims 1 to 21, further comprising a controller, wherein
the controller is configured to control the alignment mechanism to drive transmit coils of the N transmit coils to be respectively aligned with receive coils of different receiving devices of the at least two electronic devices.

23. A wireless charging base, configured to wirelessly charge at least two electronic devices, and comprising a power interface, an upper cover, a lower cover, an alignment mechanism, and at least two transmit coils, wherein
the alignment mechanism and the at least two transmit coils are located in a cavity formed by the upper cover and the lower cover;
the power interface is disposed on a side of the cavity;
the power interface is configured to connect a direct current transmitted by an adapter;
the transmit coils are in a one-to-one correspondence with the electronic devices, each of the at least two transmit coils forms a corresponding charging region on a charging plane, charging regions corresponding to two adjacent transmit coils are interconnected or overlap, and the charging plane is located on a surface, of surfaces of the wireless charging device, that is used for placing the electronic device; and
the alignment mechanism is configured to drive transmit coils of the at least two transmit coils to be respectively aligned with receive coils of different receiving devices of the at least two electronic devices, so that the transmit coils wirelessly charge the corresponding electronic devices.

24. The base according to claim 23, wherein the at least two transmit coils comprise N transmit coils, and the N transmit coils simultaneously wirelessly charge N different electronic devices.
